(19) Europäisches Patentamt
European Patent Office
Office européen des brevets

(11) **EP 1 887 728 B1**

(12) **EUROPEAN PATENT SPECIFICATION**

(45) Date of publication and mention
of the grant of the patent:
**17.05.2017  Bulletin 2017/20**

(51) Int Cl.:
***G09G 3/00*** *(2006.01)*       ***G09G 3/3233*** *(2016.01)*

(21) Application number: **07252772.4**

(22) Date of filing: **11.07.2007**

(54) **Organic light emitting display and driving method of inspection circuit of organic light emitting display**

Organische lichtemittierende Anzeige und Ansteuerungsverfahren der Prüfschaltung einer organischen lichtemittierenden Anzeige

Affichage électroluminescent organique et procédé de commande de circuit d inspection d affichage électroluminescent organique

(84) Designated Contracting States:
**DE FR GB HU PL**

(30) Priority: **09.08.2006  KR 20060075175**

(43) Date of publication of application:
**13.02.2008  Bulletin 2008/07**

(73) Proprietor: **Samsung Display Co., Ltd.**
**Gyeonggi-do (KR)**

(72) Inventors:
• **Kwak, Won-Kyu,**
**c/o Samsung SDI Co. Ltd.**
**Yongin-si,**
**Kyunggi-do (KR)**
• **Jeong, Jin Tae,**
**c/o Legal & IP Team, Samsung SDI Co. Ltd.**
**Suwon-si, Gyeonggi-do (KR)**

(74) Representative: **Mounteney, Simon James**
**Marks & Clerk LLP**
**90 Long Acre**
**London**
**WC2E 9RA (GB)**

(56) References cited:
**EP-A2- 1 635 315        EP-A2- 1 843 318**
**US-A1- 2002 075 248    US-A1- 2004 056 828**
**US-A1- 2005 122 297**

• **"Chap 5.2.1" In: Jaume Segura, Charles F. Hawkins: "CMOS electronics:how it works, how it fails" 1 April 2004 (2004-04-01), Wiley-IEEE Press , XP002606993 ISBN: 978-0-471-47669-6 , pages 137-139 * figure 5.18 ***
• **William J. Dally, John W. Poulton: "Digital Systems Engineering" 1998, Cambridge University Press , XP002606994 ISBN: 9780521592925 , pages 588-590 * figure 12.25 ***

EP 1 887 728 B1

Description

BACKGROUND OF THE INVENTION

1. Field of the Invention

The present invention relates to an organic light emitting diode (OLED) display, an inspection circuit of an OLED display, and a driving method thereof.

2. Description of the Related Art

With the development of the electronics industry and the increase in the amount of information, there has been much research in active progress for developing a large screen display. Flat panel displays providing a large screen and low power consumption have been introduced to address these issues. Examples thereof include a liquid crystal display (LCD), a plasma display panel (PDP), and an organic light emitting diode (OLED) display. Particularly, OLED displays have been receiving attention as a flat panel display that can be made extremely thin, lightweight and as having superior color reproducibility. An OLED display may have various additional advantages, e.g., a faster response speed than an LCD, superior luminance due to its self emission, a simple structure, and an easy manufacturing process. Therefore, an OLED display can be used for various products, e.g., a backlight, a portable terminal, a GPS system, a laptop computer, and a large screen TV.

Generally, in an OLED display, a first line extending in a first direction for receiving a scan signal and a light emission control signal may be disposed around an organic light emitting diode, a second line extending in a second direction for applying a data signal may be disposed to cross the first line, and a pixel may be disposed at an intersection between the first and second lines. Since such an OLED display may be manufactured through a plurality of manufacturing processes, the manufacturing cost thereof may increase and the reliability may be degraded according to defects caused during the manufacturing processes.

A conventional method of inspecting a sheet having a plurality of cells may generate a defect at a scan line as a result of interference between adjacent cells, and may induce malfunctions of turning on/off adjacent cells because of a voltage drop caused by leakage current. However, this method cannot measure the power consumption of a scan driver in a sheet unit before scribing.

The above information disclosed in this Background section is only for enhancement of understanding of the background of the invention and therefore it may contain information that does not form the prior art that is already known in this country to a person of ordinary skill in the art.

EP1635315 discloses an image display unit that includes a cathode electrode driving portion which applies a cathode electrode applied voltage to a cathode electrode, a gate electrode driving portion which sequentially applies a gate electrode applied voltage to a gate electrode according to an inputted shift clock for gate electrode selection, and an abnormality detecting portion which detects at least either an input abnormality in the shift clock for gate electrode selection or an operation abnormality in a shift register.

Document EP1843318A2 disclosesan OLED display and a testing method wherein the organic light emittingdisplay can separately turn off particular light emitting devices.

SUMMARY OF THE INVENTION

The present invention is therefore directed to an organic light emitting diode (OLED) display and a driving method of an inspection circuit of an OLED display, which substantially overcome one or more of the problems due to the limitations and disadvantages of the related art.

It is therefore an object of the present invention to provide an OLED display and a driving method of an inspection circuit of an OLED display for reducing or preventing interference between cells.

Another object of the present invention to provide an OLED display and a driving method of an inspection circuit of an OLED display for preventing or reducing a voltage drop generated during a sheet inspection.

Yet another object of the present invention is to provide an OLED display and a driving method of an inspection circuit of an OLED display for measuring the power consumption of a scan driver.

Accordingly, a first aspect of the present invention provides an organic light emitting diode (OLED) display, as set out in Claim 1. Preferred features are set out in Claims 2 to 11.

A second aspect of the present invention provides a driving method of an inspection circuit in an organic light emitting diode (OLED) display as set out in Claim 12. Preferred features are set out in Claims 13 to 20.

## BRIEF DESCRIPTION OF THE DRAWINGS

The above and other features and advantages of the present invention will become more apparent to those of ordinary skill in the art by describing in detail embodiments thereof with reference to the attached drawings, in which:

FIG. 1 illustrates a schematic plan view of an organic light emitting diode (OLED) display according to an embodiment of the present invention;
FIG. 2 illustrates a schematic diagram of a first signal input section according to an embodiment of the present invention;
FIG. 3 illustrates a schematic diagram of a second signal input section according to an embodiment of the present invention;
FIG. 4 illustrates a schematic diagram of a signal receiving unit according to an embodiment of the present invention;
FIG. 5 illustrates a schematic diagram of a pixel circuit according to an embodiment of the present invention; and
FIG. 6 illustrates a timing diagram of a previous scan signal for inspection, a current scan signal, and a light emission control signal according to an exemplary embodiment of the present invention.

## DETAILED DESCRIPTION OF THE INVENTION

As will be described in detail below, an organic light emitting diode (OLED) display and a method for driving an inspection circuit of the OLED display according to embodiments of the present invention are provided, which may reduce or prevent interference between cells and/or a voltage drop while inspecting a sheet including the OLED display.

In the following detailed description, only certain embodiments of the present invention have been shown and described, simply by way of illustration. As those skilled in the art would realize, the described embodiments may be modified in various different ways, all without departing from the scope of the present invention. In order to clearly describe the present invention, parts of the drawings unrelated to the description of the present invention have been omitted. Like reference numerals designate like elements throughout the specification.

When a first part is referred to as being "connected" to a second part, it could mean that the first part is directly connected to the second part, and it could also mean that the first part and the second part are "electrically connected" having a third element between them. Furthermore, when a part is referred to as "including" a constituent element, it does not mean that the part excludes other constituent elements, but it means that the part can further include other constituent elements, unless otherwise specified.

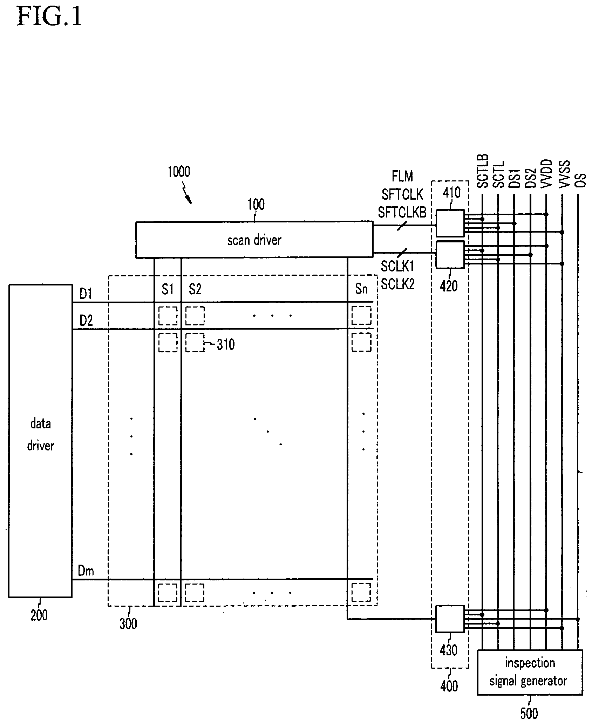

FIG. 1 illustrates a schematic plan view of a cell of a circuit that is a subject of an inspecting method according to an embodiment of the present invention.

As shown in FIG. 1, a cell 1000 of an original circuit includes a scan driver 100, a data driver 200, a display unit 300, and an inspection circuit 400 of an OLED display. The cell 1000 is connected to a first power supply line supplying a power voltage VVDD, a second power supply line supplying a power voltage VVSS, first and second inspection signal supply lines that supply first and second inspection signals DS1 and DS2, a scan signal supply line that supplies an output signal OS corresponding to a scan signal scan[n], and a first control signal line SCTL and a second control signal line SCTLB that supplies a first control signal and a second control signal, respectively.

The scan driver 100 receives a frame pulse FLM, a first shiftclock signal SFTCLK, a second shiftclock signal SFTCLKB, a first clock signal SCLK1, and a second clock signal SCLK2, and may generate a scan signal to be supplied to a respective scan line S1-Sn.

The data driver 200 generates a data signal corresponding to an externally input image input signal, and may supply the data signal to a respective data line D1-Dm.

The display unit 300 includes a plurality of pixel circuits 310. Each pixel circuit 310 includes an organic light emitting element, a switch, a capacitor, and a driving transistor. Each pixel circuit 310 is disposed at a region where the scans line S1-Sn and the data lines D1-Dm intersect each other. Each pixel circuit 310 is connected to respective ones of the scan lines S1-Sn and the data lines D1-Dm, and a current corresponding to the data signal input in response to a scan signal is generated. This current is supplied to the organic light emitting element, and the organic light emitting element emits light in response to the current.

The inspection circuit 400 receives the first control signal SCTL, the second control signal SCTLB, and the first and the second inspection signals DS1 and DS2, and generates the frame pulse FLM, the first shiftclock signal SFTCLK, the second shiftclock signal SFTCLKB, the first clock signal SCLK1, and the second clock signal SCLK2 to be output to the scan driver 100. The first control signal SCTL and the second control signal SCTLB are signals having inverse phases with respect to each other.

The inspection circuit 400 includes a first signal input section 410, a second signal input section 420, and a signal receiving unit 430. The first signal input section 410 generates the frame pulse FLM, the first shiftclock signal SFTCLK, and the second shiftclock signal SFTCLKB, and outputs them to the scan driver 100. The second signal input section 420 generates the first clock signal SCLK1 and the second clock signal SCLK2, and outputs them to the scan driver 100. The signal receiving unit 430 receives the scan signal output from at least one of the scan lines S1-Sn of the display unit 300, and generates and outputs the output signal OS corresponding to the received scan signal scan[n]. A scan waveform may be measured using the signal output from the signal receiving unit 430, and a power consumption level of the scan driver 100 may be measured.

Although the inspection circuit 400 illustrates only the first signal input section and the second signal input section in FIG. 1 consistent with the embodiment of the present invention, the frame pulse FLM, the first shiftclock signal SFTCLK, the second shiftclock signal SFTCLKB, the first clock signal SCLK1, and the second clock signal SCLK2 may be generated in a separate signal input section. However, since the frame pulse FLM, the first shiftclock signal SFTCLK, and the second shiftclock signal SFTCLKB may be generated in the first signal input section 410 having substantially the same structure, only one first signal input section 410 is illustrated for better understanding and ease of description. Furthermore, since the first clock signal SCLK1 and the second clock signal SCLK2 may be generated in the second signal input section having substantially the same structure, only one second signal input section 420 is illustrated for better understanding and ease of description.

As shown in FIG. 1, a inspection signal generator 500 generates the first and second inspection signals DS1 and DS2, the first power voltage VVDD, the second power voltage VVSS, and the first and second control signals SCTL and SCTLB, and supplies the same to a sheet including the cell 1000. The inspection signal generator 500 receives the signal OS output from the cell 1000 that is subjected to the inspection. The power consumption level of the scan driver 100 is measured according to the received signal. FIG. 1 illustrates that the signal receiving unit 430 receives the scan signal output from the scan line Sn. However, the present invention is not limited to this. The signal receiving unit 430 may receive two or more scan signals to measure waveforms of each scan signal, and the power consumption level of the scan driver 100 may be measured according to the measured waveforms of the scan signals.

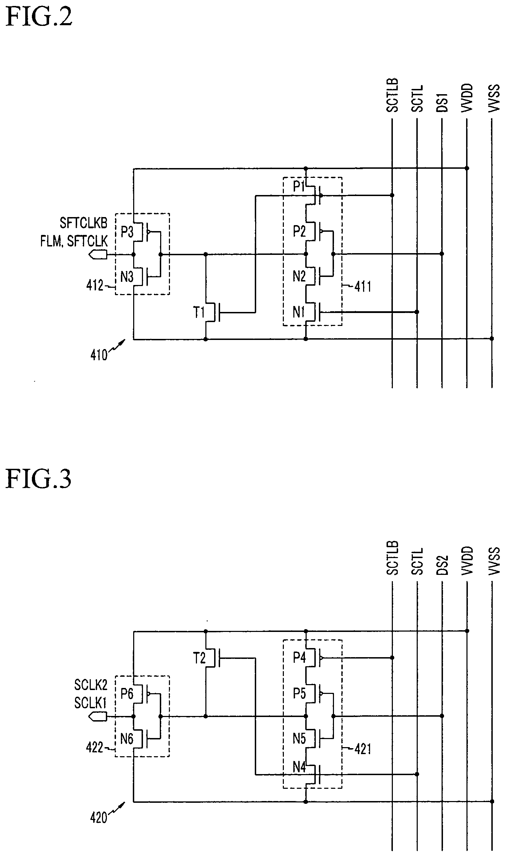

FIG. 2 illustrates a schematic diagram of the first signal input section 410 according to an embodiment of the present invention.

The first signal input section 410 consistent with the embodiment of the present invention generates the frame pulse FLM, the first shiftclock signal SFTCLK, and the second shiftclock signal SFTCLKB, in accordance with the first power voltage VVDD and/or the second power voltage VVSS.

As shown in FIG. 2, the first signal input section includes a tri-state inverter 411, a first inverter 412, and a first transistor T1. Hereinafter, a transistor consistent with the embodiment of the present invention includes a source electrode, a drain electrode, and a gate electrode as a first electrode, a second electrode, and a control electrode, respectively. Furthermore, a complementary metal oxide semiconductor (CMOS) may be used as a complementary semiconductor.

The tri-state inverter 411 includes two PMOS transistors P1 and P2, and two NMOS transistors N1 and N2. The two PMOS transistors P1 and P2 form a first inverter sub-circuit unit of the tri-state inverter, and the two NMOS transistor N1 and N2 form a second inverter sub-circuit unit of the tri-state inverter. Furthermore, the PMOS transistor P2 and the NMOS transistor N2 form one CMOS inverter. A node where the first inverter sub-circuit unit and the second inverter sub-circuit unit meet serves as an output terminal of the tri-state inverter 411.

The second control signal SCTLB is supplied to a gate electrode of the PMOS transistor P1, and the first control signal SCTL is supplied to a gate electrode of the NMOS transistor N1. At this time, if the first and second control signals SCTL and SCTLB have a high level and a low level, respectively, the PMOS transistor P1 and the NMOS transistor N1 are turned on. Thus, an output may be determined according to the first inspection signal DS1, which is supplied to gate electrodes of the PMOS transistor P2 and the NMOS transistor N2. If the first inspection signal DS1 has a high level, then the NMOS transistor N2 is turned on. At this time, if the first control signal SCTL has a high level, the voltage of the second power supply VVSS is output to an output terminal of the tri-state inverter. If the first inspection signal DS1 has a low level, then the PMOS transistor P2 is turned on. At this time, if the second control signal SCTLB has a low level, the first power voltage VVDD is output to an output terminal of the tri-state inverter.

The second control signal SCTLB is supplied to a gate electrode of the first transistor T1. A drain electrode of the first transistor T1 is connected to the output terminal of the tri-state inverter 411, and a source electrode of the first transistor T1 is connected to the second power voltage WSS. An input terminal of the first inverter 412 is connected to the output terminal of the tri-state inverter 411 and the drain electrode of the first transistor T1.

An output terminal of the first inverter 412 is connected to the scan driver 100. The first transistor T1 is turned on when an output of the tri-state inverter 411 is determined by the first and second control signals SCTL and SCTLB regardless of the input signal, and supplies the voltage of the second power voltage VVSS to the first inverter 412. If the first and second control signals SCTL and SCTLB have a low level and a high level, respectively, then the PMOS transistor P1 and the NMOS transistor N1 are both turned off. Thus, an output may be determined regardless of the input signal. At this time, the first transistor T1 is turned on, and supplies the second power voltage VVSS to the input terminal of the first inverter 412.

The first inverter 412 includes a CMOS transistor having a PMOS transistor P3 and an NMOS transistor N3. If an input voltage is the first power voltage VVDD, then the voltage of the second power supply WSS is output. If the input voltage is the second power voltage WSS, then the first power voltage VVDD is output. Consistent with the embodiment of the present invention, the first power voltage VVDD may be a voltage of a high level, and the second power voltage VVSS may be a voltage of a low level.

FIG. 3 illustrates a schematic diagram of the second signal input section 420 according to an embodiment of the present invention.

The second signal input section 420 generates the first clock signal SCLK1 and the second clock signal SCLK2, and may receive the first power voltage VVDD or the second power voltage WSS.

As shown in FIG. 3, the second signal input section includes a tri-state inverter 421, a second inverter 422, and a second transistor T2.

The tri-state inverter 421 includes two PMOS transistors P4 and P5, and two NMOS transistors N4 and N5. The two PMOS transistors P4 and P5 forms a third inverter sub-circuit unit of the tri-state inverter 421, and the two NMOS transistors N4 and N5 form a fourth inverter sub-circuit unit of the tri-state inverter 421. The PMOS transistor P5 and the NMOS transistor N5 form one CMOS inverter. A node where the third inverter sub-circuit unit and the fourth inverter sub-circuit unit meet serves as an output terminal of the tri-state inverter 421.

The second control signal SCTLB is supplied to a gate electrode of the PMOS transistor P4, and the first control signal SCTL is supplied to a gate electrode of the NMOS transistor N4. At this time, if the first and second control signals SCTL and SCTLB have a high level and a low level, respectively, the PMOS transistor P4 and the NMOS transistor N4 are turned on. Thus, an output may be determined according to the second inspection signal DS2. If the second inspection signal DS2 has a high level, then the NMOS transistor N5 is turned on. At this time, if the first control signal SCTL has a high level, the voltage of the second power supply WSS is output to an output terminal of the tri-state inverter 421. If the second inspection signal DS2 has a low level, then the PMOS transistor P5 is turned on. At this time, if the second control signal SCTLB has a low level, the voltage of the first power supply VVDD is output to an output terminal of the tri-state inverter 421.

The first control signal SCTL is supplied to a gate electrode of the second transistor T2. A drain electrode of the second transistor T2 is connected to the output terminal of the tri-state inverter 421, and a source electrode of the second transistor T2 is connected to the first power supply VVDD.

An input terminal of the second inverter 422 is connected to the output terminal of the tri-state inverter 421 and the drain of the second transistor T2. An output terminal of the second inverter 422 is connected to the scan driver 100. The second transistor T2 is turned on when an output of the tri-state inverter 421 is determined by the first and second control signals SCTL and SCTLB regardless of the input signal, and supplies the voltage of the first power supply VVDD to the second inverter 422. If the first and second control signals SCTL and SCTLB are a low level and a high level, respectively, then the PMOS transistor P4 and the NMOS transistor N4 are both turned off. Thus, an output may be determined regardless of the input signal. At this time, the second transistor T2 is turned on and supplies the first power voltage VVDD to the second inverter 422.

If an input voltage input to the input terminal of the second inverter 422 is the first power voltage VVDD, then the second inverter 422 outputs the second power voltage VVSS. If the input voltage input to the input terminal of the second inverter 422 is the second power voltage VVSS, then the second inverter 422 outputs the first power voltage VVDD. Consistent with the embodiment of the present invention, the first power voltage VVDD may be a voltage of a high level, and the second power voltage WSS may be a voltage of a low level.

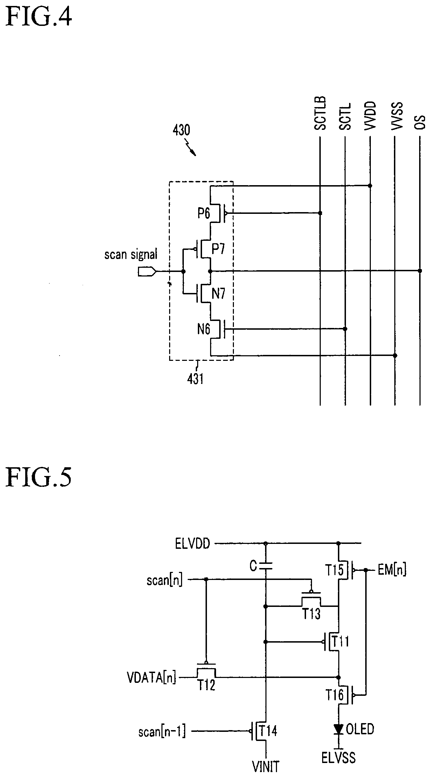

FIG. 4 illustrates a schematic diagram of a signal receiving unit 430 according to an embodiment of the present invention.

The signal receiving unit 430 has an input terminal connected to at least one of the scan lines S1-Sn, and receives a respective scan signal scan[n] applied to the scan line S1-Sn, generates the signal OS corresponding to the scan signal scan[n], and outputs the generated signal OS. The signal receiving unit 430 according to the present embodiment includes a tri-state inverter 431.

The tri-state inverter 431 includes two PMOS transistors P6 and P7, and two NMOS transistors N6 and N7. The two PMOS transistors P6 and P7 form a fifth inverter sub-circuit unit of the tri-state inverter 431, and the two NMOS transistors N6 and N7 form a sixth inverter sub-circuit unit of the tri-state inverter 431. The PMOS transistor P7 and the NMOS transistor N7 form one CMOS inverter. A node where the fifth inverter sub-circuit unit and the sixth inverter sub-circuit unit meet serves as an output terminal.

As shown in FIG. 4, the tri-state inverter 431 may output a first power voltage VVDD or a second power voltage VVSS corresponding to a scan signal scan[n] when the first control signal SCTL and the second control signal SCTLB are a high level and a low level, respectively. The scan signal scan[n] is supplied to gate electrodes of the PMOS transistor P7 and the NMOS transistor N7.

If the scan signal scan[n] has a low level, the PMOS transistor P7 is turned on. If the second control signal SCTLB has a low level when the PMOS transistor P7 is turned on, the first power voltage VVDD is supplied to the output node. Then, the signal OS output from the signal receiving unit 430 becomes the first power voltage VVDD, and is supplied to the inspection power voltage generator 500. At this time, based on the result, a low level scan signal may be applied, and it may be determined that the OLED display operates normally.

On the other hand, if the scan signal is a high level and the first control signal SCTL is a high level, NMOS transistors N6 and N7 are turned on, and the signal OS output from the signal receiving unit 430 becomes the second power voltage VVSS, and is output to the inspection signal generator 500. Then, a high level scan signal is applied, and it can be determined that the scan signal is output from the scan driver 100 normally.

A waveform of a scan signal may be estimated by measuring a signal waveform output from the signal receiving unit 430, and the power consumption of a scan driver may be measured using the estimated waveform.

According to the embodiment of the present invention, an OLED display having a target cell for inspection operates normally in a sheet.

When the OLED display of other cells except the target cell do not operate normally, a pixel circuit of each OLED display does not bias in the sheet. Accordingly, a black image may be displayed. In order for an OLED display to not operate normally, signals input to the scan driver, e.g., the frame pulse FLM, the first shiftclock signal SFTCLK, the second shiftclock signal SFTCLKB, the first clock signal CLK1, and the second clock signal SCLK2, may satisfy following conditions. The frame pulse FLM, the first shiftclock signal SFTCLK, and the second shiftclock signal sre the first power voltage VVDD, and the first clock signal CLK1 and the second clock signal SCLK2 is the second power voltage VVSS.

The inspection circuit 400 generates the frame pulse FLM, the first shiftclock signal SFTCLK, the second shiftclock signal SFTCLKB, the first clock signal CLK1, and the second clock signal SCLK2 according to an inspection signal DS if the first control signal SCTL and the second control signal SCTLB are a high level and a low level, respectively. Then, the inspection circuit 400 outputs the generated signals to the scan driver 100.

On the contrary, if the first control signal SCTL and the second control signal SCTLB are a low level and a high level, respectively, the inspection circuit 400 generates the frame pulse FLM, the first shiftclock signal SFTCLK, and the second shiftclock signal SFTCLKB as the first power voltage VVDD, and generates the first clock signal CLK1 and the second clock signal SCLK2 as the second power voltage VVDD, regardless of the inspection signal DS. Then, the inspection circuit 400 outputs the generated signal to the scan driver 100.

As described above, the OLED display according to an embodiment of the present invention may inspect desired cells from an original circuit unit without scribing.

Also, if each cell 1000 is cut off from the sheet, the inspection circuit 400 may remain at each cell 1000. That is, the inspection circuit 400 according to an embodiment of the present invention may be placed at a trimming margin where the cell 1000 is trimmed from the sheet. After cutting off the cell 1000, the inspection circuit 400 may remain at a substrate where the OLED display is formed. However, the scan driver 100 and the data driver 200 may be connected to a signal controller (not shown) when the OLED display is completely manufactured after inspection. The signal controller receives a vertical synchronization signal, a horizontal synchronization signal, a clock signal, and external image data, generates a scan signal and a data signal, and outputs them to a scan driver and a data driver.

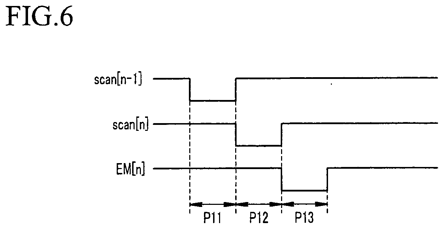

Hereinafter, in a cell 1000 having an OLED display according to an embodiment of the present invention that is a target for inspection, the operation of a pixel circuit will be described with reference to FIG. 5 and FIG. 6.

FIG. 5 illustrates a schematic diagram of a pixel circuit according to an embodiment of the present invention. FIG. 6 illustrates timing diagrams of a previous scan signal for inspection, a current scan signal, and a light emission control signal according to an exemplary embodiment of the present invention.

As shown in FIG. 5, the pixel circuit includes first to sixth transistors T11 to T16, an organic light emitting diode (OLED) element, and a capacitor C. In the pixel circuit according to an embodiment of the present invention, the scan driver 100 generates a light emission control signal EM[n].

The second transistor T12 is turned on in response to the current scan signal scan[n], and if the second transistor T12 is turned on, a data voltage VDATA is output to a first electrode of the first transistor T11. The first transistor T11 is a driving transistor, and a gate electrode of the first transistor T11 is connected to one end of the capacitor C. A source electrode of the first transistor T11 is connected to a drain electrode of the third transistor T13. The third transistor T13 is turned on in response to the scan signal scan[n]. After being turned on, the third transistor T13 diode-connects the first transistor T11. The fourth transistor T14 ise turned on in response to the previous scan signal scan[n-1]. After being turned on, an initial voltage VINIT is applied to one end of the capacitor C through the fourth transistor T14. The fifth transistor T15 and the sixth transistor T16 are turned on in response to a light emission control signal EM[n]. After being turned on, the power voltage ELVDD are supplied to the second electrode of the first transistor T11 through the fifth transistor T15. If the sixth transistor T16 is turned on, the drain current of the first transistor T11 is supplied to the OLED. The OLED may emit light corresponding to the drain current of the first transistor T11.

As can be seen in FIG. 6, at first, during a period P11, the previous scan signal scan[n-1] has a low level. Thus, the fourth transistor T14 is turned on, thereby supplying an initial voltage to one end of the capacitor C. During a period P12, the current scan signal S[n] has a low level. Thus, the third transistor T13 is turned on, thereby diode-connecting the first transistor T11 and supplying a data voltage VDATA[n] to the second electrode of the first transistor T11 through the second transistor T12. Then, the voltage at the gate electrode of the first transistor T11, the first electrode, and one end of the capacitor C becomes a voltage VDATA + VTH.

During a period P13, the light emission control signal EM[n] has a low level, thereby turning on the fifth transistor T15 and the sixth transistor T16. If the power voltage ELVDD is supplied to the first electrode of the first transistor T11, a current is generated corresponding to the voltage difference VGS of the first electrode and the gate electrode of the first transistor T11 as in Equation 1. The voltage of the gate is VDATA + VTH, and the first electrode becomes a source electrode. Therefore, a voltage VGS becomes a voltage VDATA+VTH-ELVDD. A voltage VDATA is a data voltage VDATA[n], and a voltage VTH is a threshold voltage of the first transistor T11. Then, a current is generated as in Equation 2. That is, a current is generated corresponding to a voltage compensated with the threshold voltage of the first transistor T11. Also, the power voltage ELVDD according to the present embodiment is the first power voltage VVDD or a voltage corresponding to the first power voltage VVDD.

$$I_{OLED} = \frac{\beta}{2}(VGS - VTH)^2 \qquad (1)$$

$$I_{OLED} = \frac{\beta}{2}(ELVDD - VDATA)^2 \qquad (2)$$

In Equations 1 and 2, $\beta$ is a constant that is determined depending on the characteristics of the first transistor T11.

As described above, the OLED display of a target cell for inspection in a sheet generates a current corresponding to the data voltage so that the organic light emitting element emits light, and the OLED display of a non-target cell for inspection does not emit light. Therefore, interference between adjacent cells may be prevented, and the voltage drop may be prevented because the power voltage ELVDD is not supplied to the driving transistor of the non-selected cell.

Embodiments of the present invention have been disclosed herein, and although specific terms are employed, they are used and are to be interpreted in a generic and descriptive sense only and not for purpose of limitation. Accordingly, it will be understood by those of ordinary skill in the art that various changes in form and details may be made without departing from the scope of the present invention as set forth in the following claims.

**Claims**

**1.** An organic light emitting diode (OLED) display, comprising:

a data driver (200) for applying a plurality of data signals to a plurality of data lines (D1-Dn);
a scan driver (100) for applying a plurality of scan signals to a plurality of scan lines (S1-Sn);
a driving transistor for generating a current corresponding to a voltage supplied from a first electrode and a control electrode;
a switching transistor for applying the data signal to the driving transistor;
an OLED electrically connected to the driving transistor; and
an inspection circuit (400) for inspecting the scan signal including:

a first signal input section (410) for generating and outputting to the scan driver (100) a frame pulse (FLM), a first shiftclock signal (SFTCLK), and a second shiftclock signal (SFTCLKB);
a second signal input section (420) for generating and outputting to the scan driver (100) a first clock signal (SCLK1) and a second clock signal (SCLK2); and
a signal receiving unit (430) for receiving a scan signal output from at least one of the plurality of scan lines (S1-Sn), and generating and outputting an output signal (OS) corresponding to the received scan signal;

wherein the first signal input section(410) includes:

a first transistor (T1); and
a first tri-state inverter circuit (411) having an input terminal and an output terminal, wherein the first transistor (T1) is arranged to supply a second power voltage (WSS) to the output terminal of the first tri-state inverter circuit (411) when an output signal of the first tri-state inverter circuit (411) is determined regardless of a signal input to the input terminal of the first tri-state inverter circuit (411); and

wherein the second signal input section (420) includes:

a second transistor (T2); and

a second tri-state inverter circuit (421) having an input terminal and an output terminal, wherein the second transistor (T2) supplies a first power voltage (VVDD) to the output terminal of the second tri-state inverter circuit (421) when an output signal of the second tri-state inverter circuit (421) is determined regardless of a signal input to the input terminal of the second tri-state inverter circuit (421).

2. An OLED display as claimed in claim 1, wherein the inspection circuit (400) and the OLED are arranged on a same substrate.

3. An OLED display as claimed in claim 2, wherein the first and second tri-state inverter circuits (411,421) are formed at a predetermined area on the same substrate as the scan driver (100) and the data driver (200) except areas where the scan driver and the data driver are formed.

4. An OLED display as claimed in any preceding claim, wherein the first and second tri-state inverter circuits (411,421) each comprise a complementary semiconductor.

5. An OLED display as claimed in claim 4, wherein each of the first and second tri-state inverters (411,421) further comprises:

a first transistor (P1 ,P4) for supplying the first power voltage (VVDD) to a first electrode of the complementary semiconductor in response to a first signal (SCTLB) input to a control electrode; and
a second transistor (N1,N4) for supplying the second power voltage (VVSS) to a second electrode of the complementary semiconductor in response to a second signal input (SCTL) to the control electrode.

6. An OLED display as claimed in claim 5, wherein each complementary semiconductor comprises:

a third transistor (P2,P5) for supplying the first power voltage (VVDD) to the output terminal in response to the first signal (SCTLB); and
a fourth transistor (N2,N5) for supplying the second power voltage (VVSS) to the output terminal in response to the second signal (SCTL).

7. An OLED display as claimed in claim 6, wherein the first and third transistors (P1,P4,P2,P5)are P channel transistors, and the second and fourth transistors (N1,N4,N2,N5) are N channel transistors.

8. An OLED display as claimed in any preceding claim, wherein each of the first and second tri-state inverter circuits (411,421) comprises a first node where a first inverter sub-circuit and a second inverter sub-circuit are connected in series, and the first node is the output terminal of the tri-state inverter circuit.

9. An OLED display as claimed in claim 8, wherein the first inverter sub-circuit includes a p-type metal oxide semiconductor (PMOS), and the second inverter sub-circuit includes an n-type metal oxide semiconductor (NMOS).

10. An OLED display as claimed in any preceding claim, wherein each of the first and second input sections (410,420) further comprises a two-phase inverter circuit (412,422), and an input terminal of each two-phase inverter circuit (412,422) is electrically connected to the output terminal of the respective tri-state inverter circuit (411,421).

11. An OLED display as claimed in any preceding claim, wherein each tri-state inverter circuit (411,421) is arranged to output a signal to be inspected.

12. A driving method of an inspection circuit in an organic light emitting diode (OLED) display including an OLED, a switching transistor, a scan driver (200), and an inspection circuit (400), the driving method comprising:

supplying a first control signal, a second control signal, and an inspection signal to the inspection circuit (400);
supplying at least one signal corresponding to the inspection signal to the scan driver (200) in response to the first control signal and the second control signal;
receiving a scan signal output from the a scan driver; and
generating an output signal (OS) corresponding to the received scan signal.

13. A method as claimed in claim 12, further comprising at the scan driver (200), generating a scan signal for inspection using at least one signal, and applying the inspection scan signal to a control electrode of the switching transistor.

14. A method as claimed in claim 13, further comprising receiving the inspection scan signal in response to the first control signal and the second control signal, reversing the received scan signal, and outputting the reversed scan signal.

15. A method as claimed in claim 14, wherein the inspection scan signal is received when the first control signal and the second control signal are a high level and a low level, respectively, and the received scan signal is reversed and output.

16. A method as claimed in any one of claims 13 to 15, further comprising applying the inspection scan signal to the switching transistor when the first control signal and the second control signal are a high level and a low level.

17. A method as claimed in any one of claims 13 to 16, further comprising blocking the inspection scan signal when the first control signal and the second control signal are a low level and a high level, respectively.

18. A method as claimed in any one of claims 12 to 17 wherein the inspection signal is supplied from an inspection signal generator.

19. A method as claimed in any one of claims 12 to 18 wherein;
supplying at least one signal corresponding to the inspection signal to the scan driver comprises generating the at least one signal in response to the control signal and the inverse-phase control signal.

20. A method as claimed in claim 12 or 19, wherein the inspection circuit (400) is an inspection circuit and the OLED dislay includes a power voltage line for applying a power voltage for the inspection circuit, the method further comprising
generating a scan signal using the at least one signal; and
applying the inspection power voltage to the first electrode of the switching transistor in response to the scan signal.

21. A method as claimed in claim 20, further comprising applying the inspection power voltage to the first electrode of the driving transistor when the control signal and the inverse-phase control signal are a high level and a low level, respectively.

22. The method as claimed in claim 20 or 21, further comprising blocking the inspection power voltage from the first electrode of the driving transistor when the control signal and the inverse-phase control signal are a low level and a high level, respectively.

**Patentansprüche**

1. Organische lichtemittierende Dioden- (OLED) Anzeige, umfassend:

einen Datentreiber (200) zum Anwenden einer Vielzahl von Datensignalen zu einer Vielzahl von Datenlinien (D1-Dn);
einen Scan-Treiber (100) zum Anwenden einer Vielzahl von Scan-Signalen zu einer Vielzahl von Scan-Linien (S1-Sn);
einen Ansteuerungstransistor zum Erzeugen einer Stromstärke entsprechend einer Spannung, die von einer ersten Elektrode und einer Steuerelektrode zugeführt werden;
einen Schalttransistor zum Anwenden des Datensignals zum Ansteuerungstransistor;
ein OLED, das elektrisch mit dem Ansteuerungstransistor verbunden ist; und
eine Prüfschaltung (400) zum Prüfen des Scan-Signals, enthaltend:

einen ersten Signaleingangsbereich (410) zum Erzeugen und Ausgeben eines Frame-Impulses (FLM) zum Scan-Treiber (100), ein erstes Umschaltzeitsignal (SFTCLK) und ein zweites Umschaltzeitsignal (SFTCLKB);
einen zweiten Signaleingangsbereich (420) zum Erzeugen und Ausgeben eines ersten Zeitsignals (SCLK1) und eines zweiten Zeitsignals (SCLK2) zum Scan-Treiber (100); und
eine Signalempfangseinheit (430) zum Empfangen eines Scan-Signalausgangs von mindestens einer der Vielzahl von Scan-Linien (S1-Sn), und Erzeugen und Ausgeben eines Ausgangssignals (OS) entsprechend dem empfangenen Scan-Signal;

wobei der erste Signaleingangsbereich (410) enthält:

einen ersten Transistor (T1); und

einen ersten Dreizustands-Wechselrichterkreis (411) mit einem Eingangsanschluss und einem Ausgangsanschluss, wobei der erste Transistor (T1) angeordnet ist, um eine zweite elektrische Spannung (VVSS) zum Ausgangsanschluss des ersten Dreizustands-Wechselrichterkreises (411) zuzuführen, wenn ein Ausgangssignal des ersten Dreizustands-Wechselrichterkreises (411) unabhängig von einem Signaleingang zum Eingangsanschluss des ersten Dreizustands-Wechselrichterkreises (411) bestimmt wird; und

wobei der zweite Signaleingangsbereich (420) enthält: einen zweiten Transistor (T2); und

einen zweiten Dreizustands-Wechselrichterkreis (421) mit einem Eingangsanschluss und einem Ausgangsanschluss, wobei der zweite Transistor (T2) eine erste elektrische Spannung (VVDD) zum Ausgangsanschluss des zweiten Dreizustands-Wechselrichterkreises (421) zuführt, wenn ein Ausgangssignal des zweiten Dreizustands-Wechselrichterkreises (421) unabhängig von einem Signaleingang zum Eingangsanschluss des zweiten Dreizustands-Wechselrichterkreises (421) bestimmt wird.

2. OLED-Anzeige nach Anspruch 1, wobei die Prüfschaltung (400) und die OLED auf einem selben Substrat angeordnet sind.

3. OLED-Anzeige nach Anspruch 2, wobei der erste und zweite Dreizustands-Wechselrichterkreis (411, 421) in einem vorbestimmten Bereich auf demselben Substrat wie der Scan-Treiber (100) und der Datentreiber (200) gebildet sind, außer Bereiche, wo der Scan-Treiber und der Datentreiber gebildet sind.

4. OLED-Anzeige nach einem vorherigen Anspruch, wobei der erste und zweite Dreizustands-Wechselrichterkreis (411, 421) jeweils einen komplementären Halbleiter umfasst.

5. OLED-Anzeige nach Anspruch 4, wobei jeder des ersten und zweiten Dreizustands-Wechselrichterkreises (411, 421) ferner Folgendes umfasst:

einen ersten Transistor (P1, P4) zum Zuführen der ersten elektrischen Spannung (VVDD) zu einer ersten Elektrode des komplementären Halbleiters als Antwort auf einen ersten Signal- (SCTLB) Eingang zu einer Steuerelektrode; und

einen zweiten Transistor (N1, N4) zum Zuführen der zweiten elektrischen Spannung (VVSS) zu einer zweiten Elektrode des komplementären Halbleiters als Antwort auf einen zweiten Signaleingang (SCTL) zur Steuerelektrode.

6. OLED-Anzeige nach Anspruch 5, wobei jeder komplementäre Halbleiter umfasst:

einen dritten Transistor (P2, P5) zum Zuführen der ersten elektrischen Spannung (VVDD) zum Ausgangsanschluss als Antwort auf das erste Signal (SCTLB); und

einen vierten Transistor (N2, N5) zum Zuführen der zweiten elektrischen Spannung (VVSS) zum Ausgangsanschluss als Antwort auf das zweite Signal (SCTL).

7. OLED-Anzeige nach Anspruch 6, wobei der erste und dritte Transistor (P1, P4, P2, P5) P-Kanal-Transistoren sind, und der zweite und vierte Transistor (N1, N4, N2, N5) N-Kanal-Transistoren sind.

8. OLED-Anzeige nach einem vorherigen Anspruch, wobei jeder des ersten und zweiten Dreizustands-Wechselrichterkreises (411, 421) einen ersten Knoten umfasst, wo ein erster Wechselrichter-Unterkreis und ein zweiter Wechselrichter-Unterkreis in Reihe verbunden sind, und der erste Knoten der Ausgangsanschluss des Dreizustands-Wechselrichterkreises ist.

9. OLED-Anzeige nach Anspruch 8, wobei der erste Wechselrichter-Unterkreis einen p-Kanal-Metall-Oxid-Halbleiter (PMOS) enthält, und der zweite Wechselrichter-Unterkreis einen N-Kanal-Metall-Oxid-Halbleiter (NMOS) enthält.

10. OLED-Anzeige nach einem vorherigen Anspruch, wobei jeder des ersten und zweiten Eingangsbereichs (410, 420) ferner einen Zweiphasen-Phasenwechselrichterkreis (412, 422) umfasst, und einen Eingangsanschluss von jedem Zweiphasen-Phasenwechselrichterkreis (412, 422) elektrisch mit dem Ausgangsanschluss des jeweiligen Dreizustands-Wechselrichterkreises (411, 421) verbunden ist.

11. OLED-Anzeige nach einem vorherigen Anspruch, wobei jeder Dreizustands-Wechselrichterkreis (411, 421) angeordnet ist, um ein Signal auszugeben, das geprüft werden soll.

12. Ansteuerungsverfahren einer Prüfschaltung in einer organischen lichtemittierenden Dioden- (OLED) Anzeige, enthaltend eine OLED, einen Schalttransistor, einen Scan-Treiber (200) und eine Prüfschaltung (400), wobei das Ansteuerungsverfahren Folgendes umfasst:

Zuführen eines ersten Steuersignals, eines zweiten Steuersignals und eines Prüfsignals zur Prüfschaltung (400);
Zuführen mindestens eines Signals entsprechend dem Prüfsignal zum Scan-Treiber (200) als Antwort auf das erste Steuersignal und das zweite Steuersignal;
Empfangen eines Scan-Signalausgangs von dem einen Scan-Treiber; und
Erzeugen eines Ausgangssignals (OS) entsprechend dem empfangenen Scan-Signal.

13. Verfahren nach Anspruch 12, ferner umfassend beim Scan-Treiber (200) ein Erzeugen eines Scan-Signals zum Prüfen unter Verwendung von mindestens einem Signal und Anwenden des Scan-Prüfsignals zu einer Steuerelektrode des Schalttransistors.

14. Verfahren nach Anspruch 13, ferner umfassend Empfangen des Scan-Prüfsignals als Antwort auf das erste Steuersignal und das zweite Steuersignal, Umkehren des empfangenen Scan-Signals und Ausgeben des umgekehrten Scan-Signals.

15. Verfahren nach Anspruch 14, wobei das Scan-Prüfsignal empfangen wird, wenn das erste Steuersignal und das zweite Steuersignal ein hoher Pegel bzw. ein niedriger Pegel sind, und das empfangene Scan-Signal umgekehrt und ausgegeben wird.

16. Verfahren nach einem der Ansprüche 13 bis 15, ferner umfassend ein Anwenden des Scan-Prüfsignals zum Schalttransistor, wenn das erste Steuersignal und das zweite Steuersignal ein hoher Pegel und ein niedriger Pegel sind.

17. Verfahren nach einem der Ansprüche 13 bis 16, ferner umfassend ein Blockieren des Scan-Prüfsignals, wenn das erste Steuersignal und das zweite Steuersignal ein hoher Pegel bzw. ein niedriger Pegel sind.

18. Verfahren nach einem der Ansprüche 12 bis 17, wobei das Prüfsignal von einem Prüfsignalgenerator zugeführt wird.

19. Verfahren nach einem der Ansprüche 12 bis 18 wobei; ein Zuführen mindestens eines Signals entsprechend dem Prüfsignal zum Scan-Treiber ein Erzeugen des mindestens einen Signals als Antwort auf das Steuersignal und das Umkehrphasen-Steuersignal umfasst.

20. Verfahren nach Anspruch 12 oder 19, wobei die Prüfschaltung (400) eine Prüfschaltung ist und die OLED-Anzeige eine elektrische Spannungslinie zum Anwenden einer elektrischen Spannung für die Prüfschaltung enthält, wobei das Verfahren ferner umfasst
Erzeugen eines Scan-Signals unter Verwendung von dem mindestens einen Signal; und
Anwenden der elektrischen Prüfspannung zur ersten Elektrode des Schalttransistors als Antwort auf das Scan-Signal.

21. Verfahren nach Anspruch 20, ferner umfassend ein Anwenden der elektrischen Prüfspannung zur ersten Elektrode des Ansteuerungstransistors, wenn das Steuersignal und das Umkehrphasen-Steuersignal ein hoher Pegel bzw. ein niedriger Pegel sind.

22. Verfahren nach Anspruch 20 oder 21, ferner umfassend ein Blockieren der elektrischen Prüfspannung von der ersten Elektrode des Ansteuerungstransistors, wenn das Steuersignal und das Umkehrphasen-Steuersignal ein niedriger Pegel bzw. ein hoher Pegel sind.

**Revendications**

1.  Affichage de diode électroluminescente organique (OLED), comprenant :

    un pilote de données (200) destiné à appliquer une pluralité de signaux de données à une pluralité de lignes de données (D1-Dn) ;
    un pilote de balayage (100) destiné à appliquer une pluralité de signaux de balayage à une pluralité de lignes de balayage (S1-Sn) ;
    un transistor de commande destiné à générer un courant correspondant à une tension fournie à partir d'une première électrode et d'une électrode de commande ;
    un transistor de commutation destiné à appliquer le signal de données au transistor de commande ;
    une diode OLED connectée électriquement au transistor de commande ; et
    un circuit d'inspection (400) destiné à inspecter le signal de balayage, incluant :

    une première section d'entrée de signal (410) destinée à générer et à délivrer en sortie, au pilote de balayage (100), une impulsion de trame (FLM), un premier signal d'horloge de décalage (SFTCLK) et un second signal d'horloge de décalage (SFTCLKB) ;
    une seconde section d'entrée de signal (420) destinée à générer et à délivrer en sortie, au pilote de balayage (100), un premier signal d'horloge (SCLK1) et un second signal d'horloge (SCLK2) ; et
    une unité de réception de signal (430) destinée à recevoir un signal de balayage délivré en sortie à partir d'au moins l'une de la pluralité de lignes de balayage (S1-Sn), et à générer et à délivrer en sortie un signal de sortie (OS) correspondant au signal de balayage reçu ;

    dans lequel la première section d'entrée de signal (410) inclut :

    un premier transistor (T1) ; et
    un premier circuit inverseur à trois états (411) présentant une borne d'entrée et une borne de sortie, dans lequel le premier transistor (T1) est agencé de manière à fournir une seconde tension d'alimentation (VVSS) à la borne de sortie du premier circuit inverseur à trois états (411) lorsqu'un signal de sortie du premier circuit inverseur à trois états (411) est déterminé indépendamment d'un signal appliqué en entrée à la borne d'entrée du premier circuit inverseur à trois états (411) ; et

    dans lequel la seconde section d'entrée de signal (420) inclut :

    un deuxième transistor (T2) ; et
    un second circuit inverseur à trois états (421) présentant une borne d'entrée et une borne de sortie, dans lequel le deuxième transistor (T2) fournit une première tension d'alimentation (VVDD) à la borne de sortie du second circuit inverseur à trois états (421) lorsqu'un signal de sortie du second circuit inverseur à trois états (421) est déterminé indépendamment d'un signal appliqué en entrée à la borne d'entrée du second circuit inverseur à trois états (421).

2.  Affichage OLED selon la revendication 1, dans lequel le circuit d'inspection (400) et la diode OLED sont agencés sur un même substrat.

3.  Affichage OLED selon la revendication 2, dans lequel les premier et second circuits inverseurs à trois états (411, 421) sont formés au niveau d'une zone prédéterminée sur un même substrat que celui du pilote de balayage (100) et du pilote de données (200), à l'exception de zones où le pilote de balayage et le pilote de données sont formés.

4.  Affichage OLED selon l'une quelconque des revendications précédentes, dans lequel les premier et second circuits inverseurs à trois états (411, 421) comportent chacun un semi-conducteur complémentaire.

5.  Affichage OLED selon la revendication 4, dans lequel chacun des premier et second circuits inverseurs à trois états (411, 421) comporte en outre :

    un premier transistor (P1, P4) destiné à fournir la première tension d'alimentation (VVDD) à une première électrode du semi-conducteur complémentaire en réponse à un premier signal (SCTLB) appliqué en entrée à une électrode de commande ; et
    un deuxième transistor (N1, N4) destiné à fournir la seconde tension d'alimentation (WSS) à une seconde électrode du semi-conducteur complémentaire en réponse à un second signal (SCTL) appliqué en entrée à l'électrode de commande.

6.  Affichage OLED selon la revendication 5, dans lequel chaque semi-conducteur complémentaire comporte :

    un troisième transistor (P2, P5) destiné à fournir la première tension d'alimentation (VVDD) à la borne de sortie en réponse au premier signal (SCTLB) ; et
    un quatrième transistor (N2, N5) destiné à fournir la seconde tension d'alimentation (VVSS) à la borne de sortie en réponse au second signal (SCTL).

7.  Affichage OLED selon la revendication 6, dans lequel les premier et troisième transistors (P1, P4, P2, P5) sont des transistors à canal « P » et les deuxième et quatrième transistors (N1, N4, N2, N5) sont des transistors à canal « N ».

8.  Affichage OLED selon l'une quelconque des revendications précédentes, dans lequel chacun des premier et second circuits inverseurs à trois états (411, 421) comporte un premier noeud où un premier sous-circuit inverseur et un second sous-circuit inverseur sont connectés en série, et le premier noeud correspond à la borne de sortie du circuit inverseur à trois états.

9.  Affichage OLED selon la revendication 8, dans lequel le premier sous-circuit inverseur inclut un semi-conducteur à oxyde métallique de type « p » (PMOS), et le second sous-circuit inverseur inclut un semi-conducteur à oxyde métallique de type « n » (NMOS).

10. Affichage OLED selon l'une quelconque des revendications précédentes, dans lequel chacune des première et seconde sections d'entrée (410, 420) comporte en outre un circuit inverseur à deux phases (412, 422), et dans lequel une borne d'entrée de chaque circuit inverseur à deux phases (412, 422) est connectée électriquement à la borne de sortie du circuit inverseur à trois états respectif (411, 421).

11. Affichage OLED selon l'une quelconque des revendications précédentes, dans lequel chaque circuit inverseur à trois états (411, 421) est agencé de manière à délivrer en sortie un signal à inspecter.

12. Procédé de commande d'un circuit d'inspection dans un affichage de diode électroluminescente organique (OLED) incluant une diode OLED, un transistor de commutation, un pilote de balayage (200) et un circuit d'inspection (400), le procédé de commande comprenant les étapes ci-dessous consistant à :

    fournir un premier signal de commande, un second signal de commande et un signal d'inspection au circuit d'inspection (400) ;
    fournir au moins un signal correspondant au signal d'inspection, au pilote de balayage (200), en réponse au premier signal de commande et au second signal de commande ;
    recevoir un signal de balayage délivré en sortie à partir du pilote de balayage ; et
    générer un signal de sortie (OS) correspondant au signal de balayage reçu.

13. Procédé selon la revendication 12, comportant en outre, au niveau du pilote de balayage (200), l'étape consistant à générer un signal de balayage, à des fins d'inspection, en utilisant au moins un signal, et l'étape consistant à appliquer le signal de balayage d'inspection à une électrode de commande du transistor de commutation.

14. Procédé selon la revendication 13, comportant en outre l'étape consistant à recevoir le signal de balayage d'inspection en réponse au premier signal de commande et au second signal de commande, l'étape consistant à inverser le signal de balayage reçu, et l'étape consistant à délivrer en sortie le signal de balayage inversé.

15. Procédé selon la revendication 14, dans lequel le signal de balayage d'inspection est reçu lorsque le premier signal de commande et le second signal de commande correspondent à un signal de niveau haut et à un signal de niveau bas, respectivement, et lorsque le signal de balayage reçu est inversé et délivré en sortie.

16. Procédé selon l'une quelconque des revendications 13 à 15, comprenant en outre l'étape consistant à appliquer le signal de balayage d'inspection au transistor de commutation lorsque le premier signal de commande et le second signal de commande correspondent à un signal de niveau haut et à un signal de niveau bas.

17. Procédé selon l'une quelconque des revendications 13 à 16, comprenant en outre l'étape consistant à bloquer le signal de balayage d'inspection lorsque le premier signal de commande et le second signal de commande correspondent à un signal de niveau haut et à un signal de niveau bas, respectivement.

18. Procédé selon l'une quelconque des revendications 12 à 17, dans lequel le signal d'inspection est fourni à partir d'un générateur de signal d'inspection.

19. Procédé selon l'une quelconque des revendications 12 à 18, dans lequel :

l'étape de fourniture d'au moins un signal correspondant au signal d'inspection, au pilote de balayage, comporte l'étape consistant à générer ledit au moins un signal en réponse au signal de commande et au signal de commande de phase inverse.

20. Procédé selon la revendication 12 ou 19, dans lequel le circuit d'inspection (400) est un circuit d'inspection et l'affichage OLED inclut une ligne de tension d'alimentation pour appliquer une tension d'alimentation pour le circuit d'inspection, le procédé comprenant en outre les étapes ci-dessous consistant à :

générer un signal de balayage en utilisant ledit au moins un signal ; et
appliquer la tension d'alimentation d'inspection à la première électrode du transistor de commutation en réponse au signal de balayage.

21. Procédé selon la revendication 20, comportant en outre l'étape consistant à appliquer la tension d'alimentation d'inspection à la première électrode du transistor de commande lorsque le signal de commande et le signal de commande de phase inverse correspondent à un signal de niveau haut et à un signal de niveau bas, respectivement.

22. Procédé selon la revendication 20 ou 21, comprenant en outre l'étape consistant à bloquer la tension d'alimentation d'inspection à partir de la première électrode du transistor de commande lorsque le signal de commande et le signal de commande de phase inverse correspondent à un signal de niveau haut et à un signal de niveau bas, respectivement.

# FIG.1

FIG.2

FIG.3

## FIG.4

430

431

scan signal

P6

P7

N7

N6

SCTLB  SCTL  VVDD  VVSS  SO

## FIG.5

ELVDD

C

scan[n]

T15 — EM[n]

T13

T11

VDATA[n] — T12

T16

scan[n-1] — T14

OLED

VINIT

ELVSS

FIG.6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1635315 A
- EP 1843318 A2